# EUROPÄISCHE PATENTSCHRIFT

(11) **EP 1 793 462 B1**
(45) Veröffentlichungstag und Bekanntmachung des Hinweises auf die Patenterteilung: **11.03.2009**
(21) Anmeldenummer: 06025133.7
(22) Anmeldetag: 05.12.2006
(51) Int. Cl.: H01S 5/183, H01S 5/14

(54) **Halbleiterbauelement und Laservorrichtung**
Semiconductor component and laser device
Composant semi-conducteur et dispositif laser

(30) Priorität: 05.12.2005 DE 102005058009; 08.03.2006 DE 102006010728
(43) Veröffentlichungstag der Anmeldung: 06.06.2007
(73) Patentinhaber: OSRAM Opto Semiconductors GmbH, 93055 Regensburg (DE)
(72) Erfinder: Müller, Martin, 93128 Regenstauf (DE)
(74) Vertreter: Epping - Hermann - Fischer

(56) Entgegenhaltungen:
- EP-A- 1 403 935
- WO-A-95/07566
- WO-A2-01/67563
- US-A1- 2003 053 506
- US-A1- 2004 076 209
- US-B1- 6 393 038
- US-B1- 6 493 371
- ZHU WENJUN ET AL: "Analysis of the operating point of a novel multiple-active-region tunneling-regenerated vertical-cavity surface-emitting laser" SOLID-STATE AND INTEGRATED-CIRCUIT TECHNOLOGY, 2001. PROCEEDINGS. 6TH INTERNATIONAL CONFERENCE ON OCT. 22-25, 2001, PISCATAWAY, NJ, USA,IEEE, Bd. 2, 22. Oktober 2001 (2001-10-22), Seiten 1306-1309, XP010576215 ISBN: 0-7803-6520-8
- KORSHAK A N ET AL: "Tunnel-junction-connected distributed-feedback vertical-cavity surface-emitting laser" APPLIED PHYSICS LETTERS, AIP, AMERICAN INSTITUTE OF PHYSICS, MELVILLE, NY, US, Bd. 73, Nr. 11, 14. September 1998 (1998-09-14), Seiten 1475-1477, XP012020922 ISSN: 0003-6951
- KNÖDL T ET AL: "Bistability in bipolar cascade VCSELs" ELECTRONICS LETTERS, IEE STEVENAGE, GB, Bd. 38, Nr. 8, 11. April 2002 (2002-04-11), Seiten 370-371, XP006018183 ISSN: 0013-5194

## Beschreibung

Die vorliegende Erfindung betrifft ein strahlungsemittierendes Halbleiterbauelement sowie eine Laservorrichtung.

Diese Patentanmeldung beansprucht die Priorität der deutschen Patentanmeldungen 10 2005 058 009.2 und 10 2006 010 728.4.

Bei elektrisch betriebenen strahlungsemittierenden Halbleiterbauelementen ist die Konversionseffizienz, d.h. das Verhältnis von im Bauelement erzeugter Strahlungsleistung zu der dem Bauelement mittels des Betriebsstroms zugeführten elektrischen Leistung von erheblicher Bedeutung. Häufig wird nur ein vergleichsweise geringer Anteil der zugeführten elektrischen Leistung in Strahlungsleistung umgewandelt. Die nicht in Strahlungsleistung umgewandelte elektrische Verlustleistung wird beispielsweise in Wärme umgewandelt und ist für die Strahlungserzeugung verloren.

Eine Aufgabe der vorliegenden Erfindung ist es, ein Halbleiterbauelement anzugeben, das vereinfacht effizienter betreibbar ist. Ferner soll eine effiziente Laservorrichtung angegeben werden.

Diese Aufgabe wird erfindungsgemäß durch ein Halbleiterbauelement mit den Merkmalen des Patentanspruchs 1 bzw. eine Laservorrichtung mit den Merkmalen des Patenanspruchs 25 gelöst. Vorteilhafte Ausgestaltungen und Weiterbildungen der Erfindung sind Gegenstand der abhängigen Patentansprüche.

Ein erfindungsgemäßes Halbleiterbauelement ist als oberflächenemittierendes Halbleiterbauelement mit einer vertikalen Emissionsrichtung ausgebildet und weist einen Halbleiterkörper mit einer Mehrzahl von zur Strahlungserzeugung geeigneten, voneinander beabstandet angeordneten aktiven Bereichen auf, wobei zwischen zwei aktiven Bereichen ein Tunnelübergang monolithisch im Halbleiterkörper integriert ist, die beiden aktiven Bereiche mittels des Tunnelübergangs im Betrieb des Halbleiterbauelements elektrisch leitend verbunden sind und das Halbleiterbauelement zum Betrieb mit einem externen Resonator vorgesehen ist.

Ein derartiges Halbleiterbauelement hat den Vorteil, dass aufgrund der Mehrzahl von aktiven Bereichen die im Halbleiterkörper erzeugte Strahlungsleistung und dementsprechend die aus dem Halbleiterbauelement ausgekoppelte Strahlungsleistung vereinfacht erhöht werden kann. Zudem kann die Konversionseffizienz von in den Halbleiterkörpern injizierten Ladungsträgern in Strahlung (Photonen) mittels der über den Tunnelübergang elektrisch leitend verbundenen aktiven Bereiche erhöht werden. Ein in einem aktiven Bereich unter Strahlungserzeugung rekombinierendes Elektron, welches in diesem aktiven Bereich hierbei vom Leitungsband in das Valenzband übergeht, kann durch den Tunnelübergang, der beispielsweise als, insbesondere im Betrieb des Halbleiterbauelements in Durchlassrichtung bezüglich der aktiven Bereiche, in Sperrrichtung gepolte Tunneldiode ausgeführt ist, hindurch tunneln und in den zweiten aktiven Bereich gelangen. Der Tunnelübergang ist bevorzugt derart ausgebildet, dass Elektronen aus dem Valenzband des einen aktiven Bereichs ins Leitungsband des anderen aktiven Bereichs tunneln und somit wiederum zur Strahlungserzeugung in dem weiteren aktiven Bereich genutzt werden können. Ein Ladungsträger kann somit mehrfach, d.h. in einer Mehrzahl von aktiven Bereichen, zur Strahlungserzeugung genutzt werden.

Insgesamt kann so bei gleichbleibender, dem Bauelement zugeführter elektrischer Leistung die im Halbleiterkörper erzeugte und damit insbesondere auch die aus dem Halbleiterbauelement ausgekoppelte Strahlungsleistung gegenüber einem Halbleiterkörper mit einer geringeren Anzahl an aktiven Bereichen erhöht werden. Weiterhin kann mit Vorteil die aus dem Halbleiterbauelement, insbesondere dem Halbleiterkörper, ausgekoppelte Strahlungsleistung bezogen auf den Flächeninhalt einer Strahlungsauskoppelfläche des Halbleiterkörpers, der bevorzugt gleich dem eines Halbleiterkörpers mit nur einem aktiven Bereich ist, erhöht werden. Das Halbleiterbauelement weist somit insgesamt erhöhte Konversionseffizienz auf.

Unter einer vertikalen Emissionsrichtung kann hierbei im Zweifel eine Emissionsrichtung im Wesentlichen senkrecht zu einer Oberfläche, insbesondere einer Hauptfläche, der aktiven Bereiche, die bevorzugt parallel zueinander im Halbleiterkörper angeordnet sind, verstanden werden.

Die Druckschrift US 6,493,371 offenbart eine Vorrichtung mit vertikalem Resonator. Die Vorrichtung umfasst einen ersten Spiegel, ein Substrat, einen zweiten Spiegel der an das Substrat angekoppelt ist und ein erstes und zweites aktives Gebiet. Beide aktiven Gebiete sind zwischen dem ersten und zweiten Spiegel angeordnet. Weiterhin befinden sich eine Oxidschicht und ein Tunnelübergang zwischen beiden Spiegeln.

Eine erfindungsgemäße Laservorrichtung umfasst ein erfindungsgemäßes Halbleiterbauelement gemäß den Merkmalen des Anspruchs 1 und einen mittels eines dem Halbleiterbauelement zugeordneten externen Spiegels gebildeten externen Resonator.

Der externe Resonator, d.h. ein Resonator, der mittels zumindest eines Elements das, z.B. mittels eines Freiraums, vom Halbleiterbauelement beabstandet ist, gebildet ist, ist zur Erzeugung hoher Strahlungsleistung und für einen gerichteten Austritt von Strahlung aus dem Resonator besonders geeignet.

Zudem können in einem externen Resonator verglichen mit einem internen Resonator vereinfacht ein oder eine Mehrzahl von weiteren Elementen angeordnet werden. Diese können, wie z.B. ein Etalon, der, insbesondere longitudinalen, Modenselektion dienen.

Bevorzugt sind zwei aktive Bereiche zur Erzeugung von Strahlung der gleichen Wellenlänge ausgebildet. Dies kann durch gleichartige Ausführung der aktiven Bereiche, z.B. mittels gleicher Materialien und/oder des gleichen strukturellen Aufbaus der aktiven Bereiche, vereinfacht erreicht werden.

In einer bevorzugten Ausgestaltung ist im externen Resonator ein frequenzkonvertierendes, bevorzugt ein frequenzvervielfachendes, besonders bevorzugt ein frequenzverdoppelndes Element angeordnet. Mittels eines derartigen Elements kann langwellige in kurzwellige Strahlung, z.B. nicht sichtbare Strahlung, etwa infrarote Strahlung, in sichtbare Strahlung konvertiert werden. Ein nichtlineares optisches Element, z.B. ein nichtlinearer Kristall, ist zur Frequenzkonversion, insbesondere zur Frequenzverdopplung, besonders geeignet.

Bevorzugt ist das Halbleiterbauelement zum Betrieb als elektrisch gepumptes Halbleiterlaserbauelement, insbesondere als VECSEL (VECSEL: Vertical External Cavity Surface Emitting Laser) oder auch Scheibenlaser, ausgebildet.

Der externe Resonator des Halbleiterlaserbauelements kann mittels eines ersten Spiegels und eines zweiten Spiegels gebildet sein, die bevorzugt den externen Resonator begrenzen. Hierbei ist einer der Spiegel für den externen Resonator als externer Spiegel ausgeführt. Bevorzugt weist das Halbleiterbauelement zur Bildung des Resonators einen internen Spiegel auf. Einer der Resonatorspiegel ist daher bevorzugt als interner Spiegel ausgeführt.

Im Betrieb des Halbleiterlaserbauelements mit Resonator baut sich im Resonator ein Strahlungsfeld, insbesondere ein Feld stehender Wellen (Stehwellenfeld) auf, das zumindest zum Teil durch stimulierte Emission in den aktiven Bereichen verstärkt werden kann. Diese verstärkte Strahlung kann als kohärente Laserstrahlung aus dem Resonator auskoppeln.

Zwei aktive Bereiche des Halbleiterbauelements sind bevorzugt als Verstärkungsbereiche zum gemeinsamen Betrieb innerhalb des externen Resonators vorgesehen. Der Resonator ist insbesondere bevorzugt als gemeinsamer Resonator für eine Mehrzahl von aktiven Bereichen, die als Verstärkungsbereiche ausgebildet und innerhalb des Resonators angeordnet sind, ausgebildet. Dies betrifft insbesondere die beiden über den Tunnelübergang, vorzugsweise in Serie, elektrisch leitend verbundenen aktiven Bereiche. Eine Mehrzahl an Verstärkungsbereichen in einem gemeinsamen Resonator erleichtert die Erhöhung der Verstärkung im Halbleiterkörper und zudem den Betrieb des Bauelements als Hochleistungsbauelement, insbesondere als Hochleistungs-Halbleiterlaserbauelement,
z. B. als VECSEL.

Spiegel, mittels derer der Resonator gebildet ist, sind bevorzugt mit einer hohen Reflektivität, beispielsweise von 98% oder größer ausgebildet, wobei einer der Spiegel, vorzugsweise ein externer Spiegel, der als Auskoppelspiegel von Strahlung aus dem Resonator dient, bevorzugt eine entsprechend geringere Reflektivität aufweist. Die Reflektivität des Auskoppelspiegels ist hierbei zweckmäßigerweise derart groß gewählt, dass im Betrieb des Bauelements Lasertätigkeit erreichbar ist.

Über eine Mehrzahl von Verstärkungsbereichen innerhalb eines gemeinsamen Resonators kann die Verstärkung von Strahlung innerhalb des Resonators und insbesondere des Halbleiterkörpers erhöht werden. Aufgrund der erhöhten Verstärkung kann der zum Erreichen der Lasertätigkeit erforderliche Schwellstrom bzw. die Schwellstromdichte verringert werden, sodass sich auch bei geringeren Strömen bzw. Stromdichten bereits Lasertätigkeit einstellen kann.

Alternativ oder ergänzend kann die Reflektivität eines Spiegels, mittels dessen der Resonator gebildet ist, verringert werden, wobei trotz der verringerten Reflektivität aufgrund der erhöhten Verstärkung über die Mehrzahl von aktiven Bereichen noch zuverlässig Lasertätigkeit erreicht werden kann. Zweckmäßigerweise wird hierbei die Reflektivität des als Auskoppelspiegel dienenden Spiegels, z.B. des externen Spiegels, verringert, sodass die aus dem Resonator ausgekoppelte Strahlungsleistung ohne maßgebliche Erhöhung des Schwellstroms gesteigert werden kann.

In einer weiteren bevorzugten Ausgestaltung ist einer der Spiegel, mittels derer der Resonator gebildet oder begrenzt ist, insbesondere der interne Spiegel, als Braggspiegel ausgeführt. Dieser Resonator-Braggspiegel ist weiterhin bevorzugt dotiert und/oder monolithisch in den Halbleiterkörper integriert.

Bei einer bevorzugten Ausgestaltung fließt ein Pumpstrom zum elektrischen Pumpen des Halbleiterlaserbauelements durch einen der Spiegel, mittels dessen der Resonator gebildet ist, insbesondere den internen Spiegel.

Der elektrische Widerstand eines den Pumpstrom leitenden Spiegels wird aufgrund der Mehrzahl an aktiven Bereichen in einem gemeinsamen Resonator auf die Mehrzahl von aktiven Bereichen verteilt, sodass der vom Pumpstrom zu überwindende elektrische Widerstand bezogen auf die Anzahl an aktiven Bereichen gegenüber einem gleichartigen Halbleiterbauelement mit einer geringeren Anzahl an aktiven Bereichen verringert ist.

Von besonderer Bedeutung ist dies, falls der den Pumpstrom leitende Spiegel als Braggspiegel ausgeführt ist.

Ein Braggspiegel umfasst bevorzugt eine Mehrzahl von aufeinander gestapelten Schichten, insbesondere Halbleiterschichten mit unterschiedlichen Brechungsindices. Diese Schichten sind bevorzugt jeweils als λ/4-Schicht für eine vom Halbleiterbauelement zu emittierende, insbesondere im Resonator zu verstärkende, Strahlung der Wellenlänge λ ausgeführt.

Für einen an der Resonatorbildung beteiligten Braggspiegel können, um zuverlässig Lasertätigkeit zu erreichen, beispielsweise 50 oder mehr Halbleiterschichten erforderlich sein. Der elektrische Widerstand eines Braggspiegels wächst in der Regel mit der Schichtanzahl aufgrund der steigenden Anzahl an Grenzflächen. Daher weist ein Resonator-Braggspiegel oftmals einen vergleichsweise hohen Widerstand auf. Der Widerstand eines Halbleiterbauelements mit einem monolithisch in den Halbleiterkörper integrierten Resonator-Braggspiegel kann maßgeblich durch den elektrischen Widerstand des Braggspiegels bestimmt sein. Aufgrund des hohen Widerstandes des Spiegels erhöht sich demnach aufgrund des Leistungsabfalls am Braggspiegel gemäß P=RI² mit dem Widerstand R, der elektrischen Leistung P und dem Strom I, auch die für die Lasertätigkeit erforderliche, zuzuführende elektrische Pumpleistung, da am Braggspiegel Leistung abfällt. Aufgrund der Mehrzahl von aktiven Bereichen, denen ein gemeinsamer Pumpstrom über den Tunnelübergang und insbesondere den Braggspiegel zugeführt werden kann, wird der Widerstand des Halbleiterbauelements pro aktivem Bereich gegenüber einem Halbleiterbauelement mit weniger aktiven Bereichen verringert. Insgesamt wird so die Effizienz erhöht.

In einer weiteren bevorzugten Ausgestaltung ist zwischen dem Resonator-Braggspiegel und dem diesem nächstliegenden aktiven Bereich ein weiterer Tunnelübergang monolithisch im Halbleiterkörper integriert. Der Braggspiegel kann so vereinfacht mit einem vorgegebenen Leitungstyp - p-leitend oder n-leitend - ausgebildet werden, wobei weitere, zwischen dem Tunnelübergang und dem dem Braggspiegel nächstliegenden aktiven Bereich angeordnete Elemente des Halbleiterkörpers mit Vorteil vereinfacht gemäß einem Standardprozess oder einem Standardaufbau, insbesondere mit einem von demjenigen des Braggspiegels verschiedenen Leitungstyp, ausgebildet werden können. Durch geeignete Wahl des Leitungstypen des Braggspiegels kann die durch freie Ladungsträger im Braggspiegel erfolgende Absorption von Strahlung im Resonator vermindert werden. In der Folge wird die für die Verstärkung in den aktiven Bereichen verfügbare Strahlungsleistung und somit die Effizienz des Halbleiterbauelements erhöht. Ein n-leitender Braggspiegel mit einem dementsprechend nachgeschalteten Tunnelübergang ist aufgrund des gegenüber einem p-leitenden Braggspiegel oftmals geringeren Absorptionsvermögens von Strahlung durch freie Ladungsträger hierfür besonders geeignet.

In einer weiteren bevorzugten Ausgestaltung ist der Resonator und/oder das Halbleiterbauelement, insbesondere der Halbleiterkörper, derart ausgebildet, dass ein sich im Betrieb des Halbleiterbauelements innerhalb des Resonators ausbildendes, insbesondere im Halbleiterkörper zu verstärkendes, Strahlungsfeld einen Intensitätsknoten, d.h. ein Minimum in der Intensitätsverteilung des Stehwellenfeldes, innerhalb des Tunnelübergangs, der die beiden aktiven Bereiche elektrisch leitend verbindet, aufweist. Bevorzugt weist eine zu verstärkende Mode des Strahlungsfeldes einen Intensitätsknoten innerhalb des Tunnelübergangs auf. Der Resonator weist bevorzugt eine vorgegebene Resonatorlänge auf, so dass der Halbleiterkörper für die vorgegebene Resonatorlänge derart ausgebildet ist, dass ein Intensitätsknoten innerhalb des Tunnelübergangs angeordnet ist.

In einem Tunnelübergang ist das Absorptionsvermögen von Strahlung aufgrund freier Ladungsträger in der Regel besonders groß. Mittels einer Anordnung des Tunnelübergangs um oder in einem Intensitätsknoten kann die Absorption von Strahlungsleistung im Tunnelübergang gemindert oder vollständig vermieden werden.

In einer weiteren bevorzugten Ausgestaltung weist ein Tunnelübergang, insbesondere der zwischen den beiden aktiven Bereichen angeordnete Tunnelübergang oder ein dem Resonator-Braggspiegel nachgeschalteter Tunnelübergang, zwei, insbesondere dotierte, Tunnel-Halbleiterschichten verschiedener Leitungstypen auf.

Bevorzugt ist der Tunnelübergang im Halbleiterkörper zwischen zwei, insbesondere an den Tunnelübergang angrenzenden, Halbleiterschichten unterschiedlichen Leitungstyps angeordnet. Ferner weist eine Tunnel-Halbleiterschicht bevorzugt, besonders bevorzugt weisen zwei Tunnel-Halbleiterschichten, eine Dotierstoffkonzentration auf, die größer ist als die einer an den Tunnelübergang angrenzenden Schicht des jeweils gleichen Leitungstyps. Die elektrisch leitende Verbindung der beiden aktiven Bereiche kann so vereinfacht mit geringem elektrischen Widerstand ausgeführt werden.

In einer weiteren bevorzugten Ausgestaltung ist im Halbleiterkörper ein frequenzselektives Element ausgebildet. Das frequenzselektive Element kann zur gezielten Modulation der örtlichen Intensitätsverteilung im Resonator ausgebildet sein. Bevorzugt ist das frequenzselektive Element derart ausgebildet, dass in einem Bereich des Resonators und insbesondere des Halbleiterkörpers, außerhalb der aktiven Bereiche, der ein nachteilig hohes Absorptionsvermögen für Strahlung aus dem Strahlungsfeld aufweist, über die die zur Verstärkung zu Verfügung stehende Strahlungsleistung vermindert würde, nur eine vergleichsweise geringe Intensität auftreten kann. Insbesondere kann die einhüllende Kurve der Intensitätsverteilung des Strahlungsfeldes, insbesondere die einhüllende Kurve der Intensitätsverteilung einer zu verstärkenden Mode des Stehwellenfeldes, im Resonator über das frequenzselektive Element gezielt geformt und modifiziert werden.

Alternativ oder zusätzlich kann das frequenzselektive Element zur, insbesondere longitudinalen, Modenselektion ausgebildet sein. Hierdurch kann die Auswahl einer vorgegebenen, im Resonator zu verstärkenden Mode vereinfacht werden. Das frequenzselektive Element erhöht hierbei bevorzugt die Verluste für nicht im Resonator zu verstärkende Moden.

In einer weiteren bevorzugten Ausgestaltung ist das frequenzselektive Element zwischen zwei aktiven Bereichen des Halbleiterkörpers angeordnet. Weiterhin kann das frequenzselektive Element monolithisch im Halbleiterkörper integriert sein. Insbesondere kann das frequenzselektive Element bereits mit frequenzselektiver Eigenschaft epitaktisch gewachsen sein. Zusätzliche Modifikationen nach der Epitaxie sind nicht erforderlich.

In einer weiteren bevorzugten Ausgestaltung ist das frequenzselektive Element derart ausgeführt, dass die Intensität von Strahlung innerhalb des frequenzselektiven Elements, insbesondere gegenüber einem Verzicht auf das frequenzselektive Element, gemindert ist.

Das frequenzselektive Element kann einen Braggspiegel und bevorzugt einen weiteren Braggspiegel umfassen. Der (die) Braggspiegel ist (sind) vorzugsweise dotiert, sodass die Pumpstromdurchleitung durch den (die) Braggspiegel erleichtert ist. Besonders bevorzugt weisen die Braggspiegel unterschiedliche Leitungstypen auf.

Weiterhin ist das frequenzselektive Element bevorzugt frei von einem innerhalb dieses Elements angeordneten aktiven Bereich.

Über das frequenzselektive Element werden zusätzliche Phasenbedingungen, insbesondere mittels Reflexion an den Braggspiegeln, für das Strahlungsfeld im Halbleiterkörper geschaffen. Die Intensität des Strahlungsfeldes kann zwischen den Braggspiegeln des frequenzselektiven Elements mittels Reflexion an diesen Spiegeln vereinfacht verringert werden. Insbesondere betrifft dies eine Absenkung der einhüllenden Kurve der Intensitätsverteilung des Strahlungsfeldes im Halbleiterkörper zwischen den aktiven Bereichen und insbesondere innerhalb des frequenzselektiven Elements gegenüber einem Halbleiterkörper ohne ein frequenzselektives Element.

Die einhüllende Kurve der Intensitätsverteilung kann ein lokales Minimum zwischen den aktiven Bereichen - insbesondere denjenigen, zwischen denen das frequenzselektive Element angeordnet ist -, innerhalb des frequenzselektiven Elements, zwischen den Braggspiegeln des Elements und/oder im Bereich des Tunnelübergangs, aufweisen.

Alternativ oder zusätzlich kann ein lokales Maximum der einhüllenden Kurve mittels des frequenzselektiven Elements gezielt, z.B. nach außerhalb des Bereichs zwischen zwei aktiven Bereichen, verschoben sein.

Bevorzugt ist der Tunnelübergang, der die aktiven Bereiche elektrisch leitend verbindet, vom frequenzselektiven Element umgeben oder in dieses eingebettet. Aufgrund der innerhalb des frequenzselektiven Elements verminderbaren Strahlungsintensität kann im Tunnelübergang nur eine vergleichsweise geringe Strahlungsleistung absorbiert werden.

Auch bei einer Anordnung des Tunnelübergangs außerhalb eines Intensitätsknotens kann die im Tunnelübergang absorbierbare Strahlungsleistung hierdurch vereinfacht in vertretbarem Rahmen gehalten werden, insbesondere ohne dass die Lasereigenschaften eines Halbleiterlaserbauelements maßgeblich beeinträchtigt werden. So kann zum Beispiel eine Erhöhung des Schwellstroms trotz eines die aktiven Bereiche elektrisch aneinander koppelnden, absorbierenden Tunnelübergangs vereinfacht vermieden oder gemindert werden. Bei der Anordnung des Tunnelübergangs bzw. der Herstellung des Halbleiterkörpers, der bevorzugt epitaktisch auf einem Aufwachssubstrat gewachsen ist, ist somit die Fertigungstoleranz erhöht, ohne dass die Effizienz wesentlich gemindert würde. Der Bereich zwischen den Braggspiegeln des frequenzselektiven Elements ist bevorzugt frei von einem aktiven Bereich.

Das Halbleiterbauelement weist demnach bevorzugt zusätzlich zu einem an der Bildung des Resonators beteiligten Braggspiegel zumindest einen, vorzugsweise zwei, weitere im Halbleiterkörper monolithisch integrierte Braggspiegel auf.

Das frequenzselektiven Element ist zweckmäßigerweise derart ausgebildet, dass das Halbleiterlaserbauelement frei von einem Subresonator ist, d.h. frei von einem aktiven Bereich der einen gegenüber einem weiteren aktiven Bereich separaten, Lasertätigkeit erreichenden Resonator aufweist. Hierzu ist (sind) der (die) Braggspiegel des frequenzselektiven Elements zweckmäßigerweise mit derart geringen Reflektivitäten ausgebildet, dass ein Anschwingen von Lasermoden in einem Subresonator für einen aktiven Bereich verhindert wird.

In einer bevorzugten Ausgestaltung weist der Braggspiegel und/oder der weitere Braggspiegel dafür eine Reflektivität von 95% oder weniger, bevorzugt 90% oder weniger, besonders bevorzugt 80% oder weniger, insbesondere für die in den aktiven Bereichen zu verstärkende Strahlung der Wellenlänge λ, auf. Das Anschwingen von Subresonatormoden kann so vereinfacht vermindert werden. Die Reflektivität des Braggspiegels und/oder des weiteren Braggspiegels ist weiterhin bevorzugt größer als 30%, besonders bevorzugt größer als 40%. Derartige Reflektivitäten sind für die Intensitätsmodulation besonders geeignet. Je geringer die Reflektivität der einzelnen Spiegel ist, desto geringer ist auch die Gefahr des Anschwingens von Submoden. Je größer die Reflektivität ist, desto besser kann jedoch die Intensitätsverteilung beeinflusst werden.

Der Tunnelübergang ist mit besonderem Vorteil zwischen den Braggspiegeln des frequenzselektiven Elements angeordnet.

In einer weiteren bevorzugten Ausgestaltung ist zwischen zwei aktiven Bereichen eine Stromblende im Halbleiterkörper angeordnet. Bevorzugt ist die Stromblende im frequenzselektiven Element, insbesondere in einem Braggspiegel dieses Elements, angeordnet oder integriert. Der Stromfluss im Halbleiterkörper kann mittels eines elektrisch isolierenden Stromsperrbereichs der Stromblende lateral in Richtung einer elektrisch leitfähigen, stromführenden Apertur der Stromblende geführt und in vertikaler Richtung durch diese Apertur geleitet werden. Mittels der Stromblende wird der Stromfluss in lateraler Richtung konzentriert und insbesondere der Strompfad eingeschnürt. Eine Schwellstromdichte für die Lasertätigkeit ist so vereinfacht erreichbar. Gegebenenfalls kann diese Stromblende zusätzlich zu einer weiteren, z.B. entsprechend ausgeführten, Stromblende, die bevorzugt zwischen einer Oberfläche des Halbleiterkörpers und dem dieser Oberfläche nächstliegenden aktiven Bereich angeordnet ist, vorgesehen sein. Einer lateralen Stromaufweitung im Halbleiterkörper und insbesondere auch zwischen den aktiven Bereichen kann so mit Vorteil entgegengewirkt werden. Die Stromblende kann als Oxidblende, die eine Halbleiterschicht mit einem oxidierten Stromsperrbereich und einem nicht oxidierten Stromdurchlassbereich, der die Apertur bilden kann, aufweist, ausgeführt sein.

In einer weiteren bevorzugten Ausgestaltung ist der Resonator oder das Halbleiterbauelement, insbesondere der Halbleiterkörper, derart ausgebildet, dass ein aktiver Bereich gezielt derart außerhalb eines Intensitätsmaximums des Strahlungsfeldes im Resonator angeordnet ist, dass dieses Intensitätsmaximum innerhalb eines n-leitenden Halbleiterbereichs des Halbleiterkörpers, der bevorzugt an den aktiven Bereich angrenzt, liegt oder in dessen Richtung verschoben ist. Dies kann durch geeignete Ausbildung des Resonators bzw. des Halbleiterkörpers vereinfacht erreicht werden. Das Intensitätsmaximum ist vorzugsweise das dem aktiven Bereich nächstliegende Intensitätsmaximum.

Insbesondere kann hierzu ein auf der dem n-leitenden Halbleiterbereich abgewandten Seite des aktiven Bereichs angeordneter p-leitender Halbleiterbereich gezielt dünner ausgebildet werden. Für eine vorgegebene Resonatorlänge wird ein, gegebenenfalls weiterer, n-leitender Halbleiterbereich des Halbleiterkörper hierbei mit Vorzug entsprechend dicker ausgeführt. Die Gesamtdicke des Halbleiterkörpers kann so trotz des dicker ausgeführten n-leitenden Halbleiterbereichs vereinfacht unverändert bleiben. Die Absorption von Strahlung an freien Ladungsträgern ist in einem p-leitenden Halbleitermaterial oftmals größer als in einem n-leitenden Halbleitermaterial, so dass die Absorption von Strahlung durch gezielte Erhöhung der Dicke des n-leitenden Halbleiterbereich auf Kosten derjenigen des p-leitenden Halbleiterbereich vermindert wird.

In einer weiteren bevorzugten Ausgestaltung umfassen zwei aktive Bereiche des Halbleiterbauelements eine Quantentopfstruktur. Eine Quantentopfstruktur, wie eine Ein- oder insbesondere eine Mehrfach-Quantentopfstruktur, zeichnet sich durch hohe interne Quanteneffizienz bei der Umwandlung von elektrischer Leistung in Strahlungsleistung aus. Die Konversionseffizienz des Halbleiterbauelements kann so weitergehend erhöht werden. Insbesondere beinhaltet die Bezeichnung Quantentopfstruktur hierbei keine Angabe über die Dimensionalität der Quantisierung. Sie umfasst somit u.a. Quantentröge, Quantendrähte und Quantenpunkte und jede Kombination dieser Strukturen.

In einer weiteren bevorzugten Ausgestaltung enthält der Halbleiterkörper, insbesondere der Tunnelübergang, die aktiven Bereiche, der interne Spiegel, die Stromblende und/oder das frequenzselektive Element, insbesondere jeweils, ein III-V-Halbleitermaterial, insbesondere ein Material aus den III-V-Halbleitermaterialsystemen Inₓ Ga_{y} Al_{1-x-y} P, Inₓ Ga_{y} Al_{1-x-y} N und/oder Inₓ Ga_{y} Al_{1-x-y} As, jeweils mit 0≤x≤1, 0≤y≤1 und x+y≤1, und/oder ein Material aus den Halbleitermaterialsystemen InGaAsN, InGaAsSb, InGaAsSbN oder Inₓ Ga₁₋ₓAs_{y} P_{1-y} mit 0≤x≤1 und 0≤y≤1, wobei für die angegebenen Parameter x und y bevorzugt jeweils x≠0 und/oder y≠0 gilt. Weiterhin ist bevorzugt x≠1 und/oder y≠1. III-V-Halbleitermaterialien können sich durch besonders hohe Quanteneffizienzen bei der Strahlungserzeugung und vereinfachte Herstellbarkeit eines Halbleiterkörpers für das Halbleiterbauelement auszeichnen. Mit den genannten Materialsystemen kann Strahlung in verschiedenen Spektralbereichen besonders effizient erzeugt werden. Hierbei ist Inₓ Ga_{y} All_{1-x-y} N für ultraviolette Strahlung, über blaue bis zu grüner Strahlung, Inₓ Ga_{y} Al_{1-x-y} P für gelbe bis rote Strahlung und Inₓ Ga_{y} Al_{1-x-y} As für infrarote Strahlung besonders geeignet

Weitere Vorteile, Merkmale und Zweckmäßigkeiten der Erfindung ergeben sich aus der nachfolgenden Beschreibung der Ausführungsbeispiele in Verbindung mit den Figuren.
Figur 1 zeigt eine schematische Schnittansicht eines ersten Ausführungsbeispiels eines erfindungsgemäßen Halbleiterbauelements,
Figur 2 zeigt eine schematische Schnittansicht eines zweiten Ausführungsbeispiels eines erfindungsgemäßen Halbleiterbauelements,
Figur 3 zeigt eine schematische Schnittansicht eines dritten Ausführungsbeispiels eines erfindungsgemäßen Halbleiterbauelements und
Figur 4 zeigt eine schematische Schnittansicht eines vierten Ausführungsbeispiels eines erfindungsgemäßen strahlungsemittierenden Halbleiterbauelements.

Gleiche, gleichartige und gleichwirkende Elemente sind in den Figuren mit gleichen Bezugszeichen versehen.

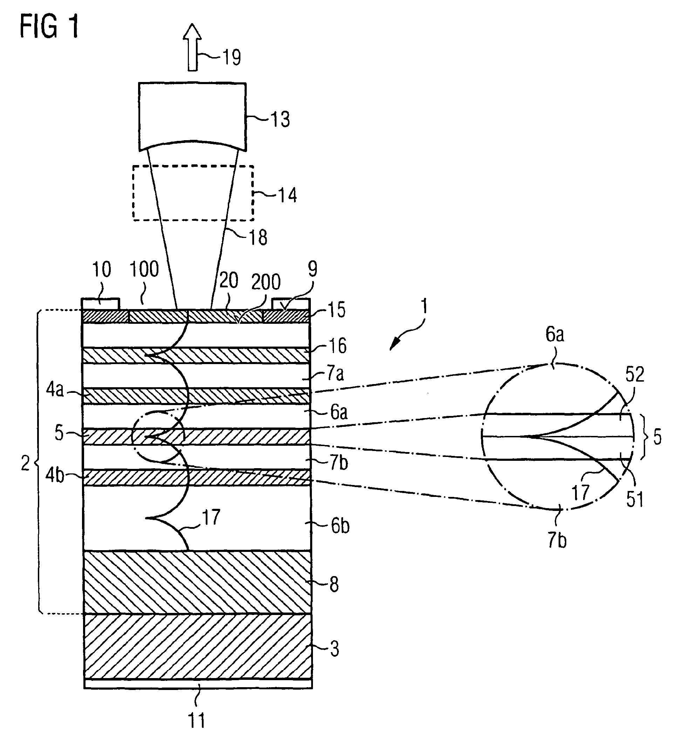

Figur 1 zeigt eine schematische Schnittansicht eines ersten Ausführungsbeispiels eines erfindungsgemäßen Halbleiterbauelements.

Das Halbleiterbauelement 1 umfasst einen Halbleiterkörper 2, der auf einem Substrat 3 angeordnet ist. Das Substrat 3 stabilisiert den Halbleiterkörper mechanisch und kann das Aufwachssubstrat, auf dem eine Halbleiterschichtenfolge für den Halbleiterkörper epitaktisch gewachsen ist, umfassen oder aus diesem gebildet sein.

Der Halbleiterkörper basiert vorzugsweise auf (In,Al)GaAs oder insbesondere auf (Al)GaAs. (Al)GaAs ist für ein effizientes strahlungsemittierendes Halbleiterbauelement, insbesondere zur Strahlungserzeugung im infraroten Spektralbereich besonders geeignet. Als Substrat 3, insbesondere als Aufwachssubstrat ist für dieses Materialsystem ein, z.B. n-leitendes, GaAs-Substrat besonders geeignet.

Der Halbleiterkörper 2 ist vorzugsweise monolithisch integriert ausgeführt und umfasst zwei, im Halbleiterkörper voneinander vertikal beabstandet und vorzugsweise im Halbleiterkörper benachbart angeordnete, zur Strahlungserzeugung geeignete aktive Bereiche 4a und 4b, die über einen zwischen diesen aktiven Bereichen angeordneten Tunnelübergang 5 in Serienschaltung elektrisch leitend verbunden sind.

Die aktiven Bereiche 4a und 4b sind jeweils zwischen zwei Halbleiterbereichen 6a und 7a bzw. 6b und 7b angeordnet, wobei die Bereiche 6a und 7a bzw. 6b und 7b besonders bevorzugt unterschiedliche Leitungstypen aufweisen. Die Halbleiterbereiche 6a und 6b bzw. 7a und 7b weisen bevorzugt jeweils den gleichen Leitungstyp auf. Die zwischen den aktiven Bereichen 4a und 4b angeordneten Halbleiterbereiche 6a und 7b grenzen ferner bevorzugt an den Tunnelübergang 5 an.

Zwischen den aktiven Bereichen und dem Substrat 3 ist ein, vorzugsweise dotierter, z.B. n-leitender, Braggspiegel 8 monolithisch im Halbleiterkörper 2 integriert. Der Braggspiegel 8 grenzt bevorzugt an das Substrat an.

Über mit den aktiven Bereichen elektrisch leitend verbundene Kontakte - einen ersten Kontakt 10 und einen zweiten Kontakt 11- wird im Betrieb des Halbleiterbauelements ein Pumpstrom zu den aktiven Bereichen 4a und 4b geleitet, in denen in der Folge durch Rekombination von Elektronen und Löchern, beispielsweise infrarote, Strahlung erzeugt wird.

Der erste Kontakt 10, beispielsweise eine Metallisierung, ist bevorzugt auf der dem Substrat 3 abgewandten Oberfläche 9 des Halbleiterkörpers 2 angeordnet. Bevorzugt ist der erste Kontakt als Ringkontakt ausgeführt. Auf der dem Halbleiterkörper 2 abgewandten Seite des Substrats 3 ist bevorzugt der zweite Kontakt 11, beispielsweise eine Metallisierung, auf dem Substrat angeordnet.

Die zwischen dem ersten Kontakt 10 und dem diesem nächstliegenden aktiven Bereich 4a angeordneten Elemente des Halbleiterkörpers weisen bevorzugt den gleichen Leitungstyp, beispielsweise p-leitend, auf. Entsprechendes gilt für die zwischen dem zweiten Kontakt 11 und dem diesem nächstliegenden aktiven Bereich 4b angeordneten Elemente. Diese sind bevorzugt n-leitend ausgeführt.

Der Braggspiegel 8 bildet zusammen mit einem externen Spiegel 13 einen gemeinsamen externen optischen Resonator für die beiden aktiven Bereiche 4a und 4b des Halbleiterbauelements.

Im Resonator baut sich im Betrieb des Halbleiterbauelements ein Strahlungsfeld auf, das in den aktiven Bereichen durch stimulierte Emission verstärkt werden kann. Der normierte Verlauf der Intensität 17 des in den aktiven Bereichen durch stimulierte Emission zu verstärkenden Stehwellenfeldes 18 ist in Figur 1 schematisch dargestellt. Das Halbleiterbauelement mit dem externen Resonator ist damit insbesondere als elektrisch gepumpter VECSEL bzw. Halbleiterscheibenlaser ausgeführt. Aufgrund der Mehrzahl von aktiven Verstärkungsbereichen die in dem gemeinsamen Resonator angeordnet sind, kann der zum Erreichen der Lasertätigkeit erforderliche Schwellstrom bzw. die Schwellstromdichte vermindert werden. Zudem wird die Konversionseffizienz von elektrischer Pumpleistung in Strahlungsleistung erhöht.

Alternativ oder zusätzlich kann die zum Erreichen der Lasertätigkeit erforderliche Reflektivität der Spiegel 8 oder 13, insbesondere die des vorliegend als Auskoppelspiegel dienenden externen Spiegels 13, verringert werden, sodass bei gleicher Strahlungsauskoppelfläche eine erhöhte Strahlungsleistung aus dem Resonator ausgekoppelt werden kann, ohne das Erreichen der Lasertätigkeit maßgeblich zu erschweren.

Da eine Mehrzahl von aktiven Bereichen zur Verstärkung von Strahlung in einem gemeinsamen Resonator zur Verfügung steht, wird die Verstärkung erhöht und zugleich der Widerstand pro Verstärkungsbereich im Halbleiterkörper verringert. Die Anzahl an Strahlungsumläufen im Resonator kann so verringert werden, wodurch die Absorption von Strahlungsleistung im Halbleiterkörper außerhalb der aktiven Bereiche verringert werden kann.

Insgesamt kann so die differenzielle Effizienz dPₒₚₜ/dI, mit der ausgekoppelten Strahlungsleistung Pₒₚₜ und dem injizierten Strom I, und/oder die differenzielle Verstärkung dg/dn, mit der Verstärkung g ("gain") und der Ladungsträgerdichte n, erhöht werden.

Zudem können die Modulationseigenschaften des Halbleiterbauelements verbessert werden. Beispielsweise kann der minimal erzielbare Pulsabstand im Pulsbetrieb des Bauelements verringert werden. Projektionsanwendungen erfordern besonders geringe Pulsabstände, so dass eine Verringerung der erzielbaren Pulsabstände für eine Projektionsanwendung, für die das Halbleiterbauelement vorgesehen sein kann, von besonderer Bedeutung ist. Hierzu ist die Resonatorlänge bevorzugt zusätzlich entsprechend gering gewählt, da mit geringerer Resonatorlänge vereinfacht geringere Pulsabstände erzielbar sind. Bevorzugt ist die Resonatorlänge kleiner oder gleich 30cm, besonders bevorzugt kleiner oder gleich 10cm.

Der externe Spiegel 13 ist bevorzugt als Auskoppelspiegel von Strahlung aus dem Resonator ausgebildet. Bevorzugt weist der externe Spiegel für die in den aktiven Bereichen zu verstärkende Strahlung der Wellenlänge λ eine Reflektivität von 95 % oder mehr, besonders bevorzugt 97 % oder mehr, beispielsweise 99% oder mehr, auf.

Die Reflektivität des Braggspiegels 8, der vorliegend vorzugsweise nicht als Auskoppelspiegel dient, ist bevorzugt größer oder gleich der Reflektivität des externen Spiegels.

Der Braggspiegel 8 weist bevorzugt eine Vielzahl von Halbleiterschichten, beispielsweise 55 oder mehr Halbleiterschichten, mit unterschiedlichen Brechungsindices auf. Diese basieren vorzugsweise jeweils auf (Al)GaAs. Für das Erzielen einer vorgegebenen Reflektivität, die für das Erreichen der Lasertätigkeit ausreicht, z.B. 99,9% oder größer, ist oftmals eine derart hohe Schichtanzahl nötig. Die Halbleiterschichten des Braggspiegels 8 sind weiterhin bevorzugt jeweils als λ/4-Schichten für in den aktiven Bereichen 4a und 4b zu verstärkende Strahlung der Wellenlänge λ ausgeführt.

Um die Schichtanzahl im Braggspiegel bei gleichbleibender Reflektivität zu verringern, werden bevorzugt Materialien mit vorteilhaft hohem Brechungsindexunterschied, etwa AlAs und GaAs, für die verschiedenen Halbleiterschichten des Braggspiegels eingesetzt. Der Braggspiegel kann Halbleiterschichtenpaare mit Einzelschichten unterschiedlicher Brechungsindices umfassen, die derart alternierend angeordnet sind, dass auf eine hochbrechende Schicht eine niedrigbrechende Schicht folgt. Alternativ oder ergänzend können Spiegelstrukturen eingesetzt werden, bei denen eine oder eine Mehrzahl von λ/4-Schichten einen Material-Gradienten, beispielsweise einen Gradienten im Al-Gehalt, aufweisen.

Aufgrund der Vielzahl von Schichten trägt der Braggspiegel 8 in hohem Maße zum gesamten elektrischen Widerstand des Halbleiterkörpers 2 bei. Da der Widerstand des Braggspiegels aufgrund der Mehrzahl von aktiven Bereichen auf diese Bereiche verteilt wird, kann die Konversionseffizienz des Halbleiterbauelements 1 von elektrischer Leistung in Strahlungsleistung gegenüber einem Bauelement mit lediglich einem aktiven Bereich in einem externen Resonator erhöht werden. Das Halbleiterbauelement ist damit zur Emission besonders hoher Strahlungsleistung geeignet.

Alternativ kann der Pumpstrom auch nicht über den Resonator-Braggspiegel 8 bzw. das Substrat 3 zu den aktiven Bereichen geleitet werden. Hierfür ist ein sogenannter Intra-Cavity-Kontakt, d.h. ein Kontakt, mittels dem Strom innerhalb des Resonators, insbesondere zwischen einem Resonatorspiegel, etwa dem Braggspiegel, und dem diesem nächstliegenden aktiven Bereich, in den Halbleiterkörper injiziert wird. Der vom Pumpstrom zu überwindende Widerstand kann so verringert werden. Der Braggspiegel 8 kann dann gegebenenfalls undotiert ausgeführt sein. Alternativ kann auch ein elektrisch isolierender dielektrischer Spiegelschichtstapel, der bevorzugt auf dem Halbleiterkörper ausgebildet ist, als Resonatorspiegel eingesetzt werden.

Im externen Resonator ist bevorzugt ein nichtlineares optisches Element 14, z.B. ein BiBo-Kristall (BiBo: Wismuthtriborat, z.B. BiB₃O₆), zur Frequenzvervielfachung, insbesondere zur Frequenzverdopplung, angeordnet.

In den aktiven Bereichen durch stimulierte Emission verstärkte, nicht sichtbare Strahlung, z.B. infrarote Strahlung, kann durch Frequenzvervielfachung im nichtlinearen optischen Element in sichtbare Strahlung umgewandelt werden, die aus dem Resonator auskoppelt.

Zwischen dem ersten Kontakt 10, der bevorzugt für den Strahlungsdurchtritt als ringartiger Kontakt ausgeführt ist, und den aktiven Bereichen kann eine Halbleiterkontaktschicht 15 ausgebildet sein, die vorliegend bevorzugt ringartig ausgebildet ist und/oder an den ersten Kontakt angrenzt. Vom ersten Kontakt 10 aus gelangen Ladungsträger über die Halbleiterkontaktschicht und nachfolgend eine Stromspreizschicht 16 zu den aktiven Bereichen. Die Stromspreizschicht 16 weist bevorzugt eine vorteilhaft hohe Leitfähigkeit in lateraler Richtung auf, sodass Ladungsträger in der Stromspreizschicht in lateraler Richtung vom Rand des Halbleiterkörpers weg in Richtung der Mitte des Halbleiterkörpers geleitet werden. Eine (Al)GaAs-Schicht mit einem Al-Gehalt von 70 % oder größer ist als Stromspreizschicht besonders geeignet. Die Gefahr von nichtstrahlender Rekombination, die in einem Randbereich des Halbleiterkörpers 2 besonders hoch ist, kann so vermindert werden.

Ladungsträger, die in einem der aktiven Bereiche strahlend rekombinieren, können nach dem Tunneln durch den Tunnelübergang 5 in den anderen aktiven Bereich gelangen. Der Tunnelübergang ist bevorzugt derart ausgebildet, dass Ladungsträger von dem Valenzband des einen aktiven Bereichs in das Leitungsband des anderen aktiven Bereichs tunneln und in diesem nochmals strahlend rekombinieren können. Die Konversionseffizienz des Halbleiterbauelements wird so vorteilhaft erhöht.

Der Tunnelübergang 5 ist bevorzugt als im Betrieb des Halbleiterbauelements, insbesondere bezüglich der Kontakte 10 und 11, in Sperrrichtung gepolte Diode ausgeführt.

Der Tunnelübergang umfasst beispielsweise zwei Tunnelschichten 51 und 52 unterschiedlichen Leitungstyps. Die Tunnelschicht 52 weist bevorzugt den gleichen Leitungstyp, insbesondere n-leitend, auf wie eine seitens der Tunnelschicht 52, d.h. an der der Tunnelschicht 51 abgewandten Seite der Tunnelschicht 52, an den Tunnelübergang 5 angrenzende Halbleiterschicht aus dem Halbleiterbereich 6a. Besonders bevorzugt weist die Tunnelschicht 52 eine höhere Dotierstoffkonzentration (z.B. n⁺) als diese angrenzende Halbleiterschicht des Halbleiterbereichs 6a auf. Entsprechendes gilt für die Tunnelschicht 51 (z.B. p⁺) bezüglich einer seitens dieser Tunnelschicht 51 an den Tunnelübergang 5 angrenzenden, insbesondere p-leitenden, Halbleiterschicht des Halbleiterbereichs 7b.

Die Tunnelschichten 51, 52 weisen bevorzugt jeweils eine Dicke von 30 nm oder weniger, besonders bevorzugt 20 nm oder weniger, auf. Die Tunnelschichten 51 und 52 können eine Dotierstoffkonzentration von beispielsweise 5x10¹⁹cm⁻³ oder mehr, bevorzugt von 1x10²⁰cm⁻³ oder mehr, aufweisen. (Al)GaAs-Schichten mit einem Al-Gehalt von 20 % oder weniger sind für die jeweilige Tunnelschicht besonders geeignet.

Die Resonatorlänge beträgt bevorzugt n*(λ/2), wobei λ die Wellenlänge der zu verstärkenden Strahlung und n eine natürliche Zahl bezeichnen. n ist bevorzugt größer oder gleich 3. n ist weiterhin bevorzugt derart gewählt, dass die Resonatorlänge kleiner oder gleich 6λ pro aktivem Bereich des Halbleiterbauelements ist.

Über eine Apertur 100 im Kontakt 10, die beispielsweise kreis- oder ellipsenartig ausgeführt ist, kann Strahlung nach dem Austritt aus dem Halbleiterkörper 2 über eine Emissionsoberfläche 200 des Halbleiterkörpers durch den ausgesparten Bereich des Kontaktes 10 treten. Am externen Spiegel 13 wird diese Strahlung zur weitergehenden Verstärkung in den aktiven Bereichen zumindest teilweise in den Halbleiterkörper 2 zurück reflektiert.

Mittels der Formgebung der Apertur kann die Polarisation der austretenden Strahlung beeinflusst werden. Hierzu ist eine in Aufsicht betrachtet ellipsenförmige Aussparung im Kontakt 10 besonders geeignet.

Um die Reflexionsverluste beim Wiedereintritt der Strahlung in den Halbleiterkörper zu mindern, ist auf der Emissionsoberfläche 200 des Halbleiterkörpers 2 bevorzugt, z.B. in einer Apertur des Kontakts 10 und/oder der Halbleiterkontaktschicht 15, eine Antireflexionsschicht oder -beschichtung 20 auf das Halbleitermaterial aufgebracht.

Die innerhalb des Resonators angeordneten Elemente des Halbleiterkörpers 2, d.h. alle Halbleiterelemente bis auf den Braggspiegel, können - abgesehen von den aktiven Bereichen 4a und 4b - bis auf gegebenenfalls unterschiedliche Leitungstypen und/oder Dotierstoffkonzentrationen die gleiche Materialzusammensetzung aufweisen. Insbesondere können der Tunnelübergang 5 und die angrenzenden Halbleiterbereiche bis auf die Dotierstoffkonzentration die gleiche Zusammensetzung aufweisen. Brechungsindexsprünge innerhalb dieser Elemente im gemeinsamen Resonator mit damit einhergehender vermehrter Reflexion an Grenzflächen können so vermindert werden.

Alternativ können für die innerhalb des Resonators angeordneten Elemente, d.h. insbesondere für den Tunnelübergang und die angrenzenden Halbleiterbereiche 6a und 7b, jeweils verschiedene Materialien eingesetzt werden. Die Freiheitsgrade für das Ausbilden dieser Elemente sind so erhöht.

Auch Kombinationen aus derart gleichartiger Ausbildung und verschiedener Ausbildung der einzelnen Halbleiterelemente im Resonator sind möglich. Beispielsweise können alle Elemente zwischen dem Braggspiegel 8 und dem Tunnelübergang 5, gegebenenfalls einschließlich des Tunnelübergangs, - bis auf den dort angeordneten aktiven Bereich - gleiche Materialzusammensetzung aufweisen. Die zwischen dem Tunnelübergang 5 und dem externen Spiegel 13 angeordneten Elemente des Halbleiterkörpers 2 können verschiedene Materialzusammensetzungen aufweisen.

Das in Figur 1 dargestellte Halbleiterbauelement 1 ist als Top-Emitter ausgebildet. Dies bedeutet, dass Strahlung den Halbleiterkörper 2 über dessen dem Substrat 3 abgewandte Seite verlässt. Die dem Substrat abgewandte Oberfläche des Halbleiterkörpers dient somit als Emissionsoberfläche 200 des vertikal zu den aktiven Bereichen 4a und 4b emittierenden Halbleiterbauelements.

Weiterhin sind die aktiven Bereiche bevorzugt gleichartig, insbesondere mit gleichen Materialien und/oder dem gleichen strukturellen Aufbau ausgebildet. Die aktiven Bereiche können zur Erzeugung von Strahlung gleicher (Peak)Wellenlängen ausgeführt sein.

Bevorzugt umfassen die aktiven Bereiche jeweils eine Ein- oder Mehrfach-Quantentopfstruktur. Diese Strukturen zeichnen sich durch besonders hohe interne Quanteneffizienzen bei der Umwandlung von elektrischer Leistung in Strahlungsleistung aus. Die Verstärkung von Strahlung im Halbleiterkörper bezogen auf die Ladungsträgerdichte kann so vereinfacht vergrößert werden.

Die aktiven Bereiche 4a und 4b sind weiterhin bevorzugt jeweils in einem Intensitätsbauch, d.h. einem Intensitätsmaximum, der Intensitätsverteilung 17 des stehenden Wellenfeldes im Resonator angeordnet. In den Verstärkungsbereichen steht dann eine besonders hohe Strahlungsleistung zur Verstärkung zur Verfügung.

Alternativ oder zusätzlich kann einer oder eine Mehrzahl von aktiven Bereichen auch gezielt außerhalb eines Intensitätsbauchs angeordnet sein. Hierüber kann die Dicke eines p-leitenden Halbleiterbereichs, insbesondere in Bereichen vergleichsweise hoher Intensität, im Halbleiterkörper verringert werden. In einem p-leitenden Bereich ist die Absorption von Strahlung durch freie Ladungsträger in der Regel besonders groß und insbesondere größer als in einem n-leitenden Bereich. Im besonderen gilt dies im AlGaAs-Materialsystem. Der jeweilige aktive Bereich ist dann bevorzugt derart zum nächstliegenden Intensitätsbauch versetzt angeordnet, dass das dem aktiven Bereich nächstliegende Intensitätsmaximum in Richtung eines n-leitenden Halbleiterbereichs verschoben ist oder in diesem liegt. Der jeweilige n-leitende Bereich, z.B. der Bereich 6b, ist hierfür auf Kosten eines dünner ausgeführten p-leitenden Bereichs entsprechend dicker ausgeführt. Auch hierüber kann trotz der Anordnung des aktiven Bereichs außerhalb eines Intensitätsbauchs die Effizienz des Halbleiterbauelements vorteilhaft erhöht werden, da Strahlung im Resonator kürzer durch p-leitendes Halbleitermaterial läuft. Die Resonatorlänge bleibt dabei bevorzugt unverändert.

Der hochabsorbierende, nicht der Verstärkung dienende Tunnelübergang ist bevorzugt in einem Intensitätsknoten der Intensitätsverteilung 17 des Stehwellenfeldes im Resonator angeordnet. Die im Tunnelübergang 5 absorbierbare Strahlungsleistung kann so minimiert werden. Diese Anordnung trägt zur Effizienzsteigerung des Halbleiterbauelements bei.

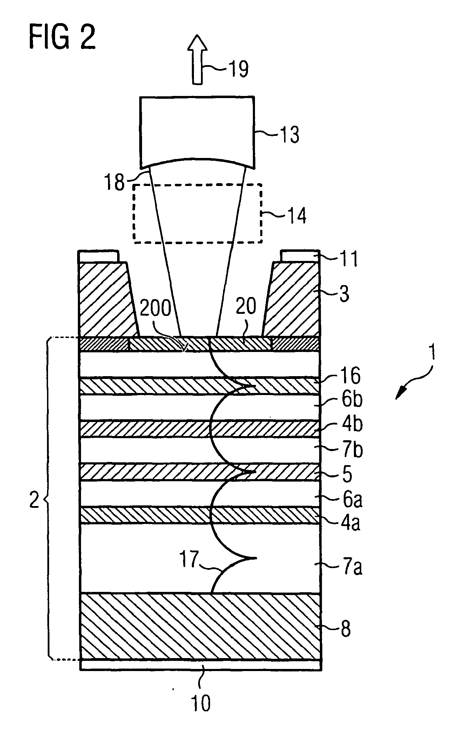

Figur 2 zeigt eine schematische Schnittansicht eines zweiten Ausführungsbeispiels eines erfindungsgemäßen Halbleiterbauelements.

Im Wesentlichen entspricht das Ausführungsbeispiel nach Figur 2 dem in Figur 1 gezeigten. Im Unterschied hierzu ist das Halbleiterbauelement 1 gemäß Figur 2 als Bottom-Emitter ausgeführt. Die Emissionsoberfläche 200 des Halbleiterbauelements ist demgemäß durch die dem Substrat 3 zugewandte Oberfläche des Halbleiterkörpers 2 gebildet. Das Substrat 3 und der zweite Kontakt 11 sind hierzu zweckmäßigerweise entsprechend ausgespart. Die Antireflexionsschicht oder - beschichtung 20 ist durch eine Apertur des Kontaktes 11 und des Substrats 3 auf dem Halbleiterkörper 2 aufgebracht. Der Braggspiegel 8 ist weiterhin im Unterschied zu dem Ausführungsbeispiel gemäß Figur 1 bevorzugt mit einem anderen Leitungstypen, zum Beispiel p-leitend ausgeführt, insbesondere falls das Substrat das Aufwachssubstrat umfasst. In diesem Falle wird mit Vorteil auf dem Substrat zunächst gemäß einem Standardprozess n-leitendes Halbleitermaterial gewachsen. Zudem ist die Stromspreizschicht 16 im Unterschied zum Ausführungsbeispiel nach Figur 1 zwischen dem zweiten Kontakt 11 und dem aktiven Bereich 4b angeordnet. Vorzugsweise ist die Stromspreizschicht 16 n-leitend ausgeführt.

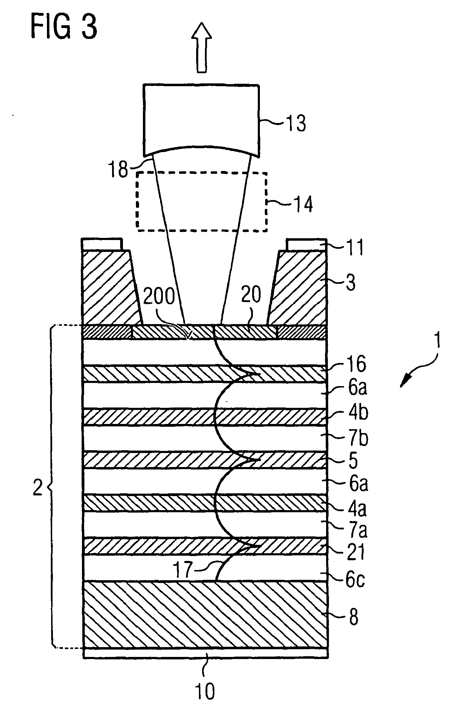

Figur 3 zeigt eine schematische Schnittansicht eines dritten Ausführungsbeispiels eines erfindungsgemäßen Halbleiterbauelements.

Im Wesentlichen entspricht das Halbleiterbauelement dem in Figur 2 gezeigten und ist insbesondere auch als Bottom-Emitter ausgeführt. Im Unterschied zum Ausführungsbeispiel gemäß Figur 2 ist im Halbleiterkörper 2 zusätzlich zum zwischen den aktiven Bereichen 4a und 4b angeordneten Tunnelübergang 5 ein weiterer Tunnelübergang 21 im Halbleiterkörper 2 monolithisch integriert.

Dieser Tunnelübergang 21 ist zwischen dem Braggspiegel 8 und dem diesem nächstliegenden aktiven Bereich 4a angeordnet. Aufgrund des zusätzlichen Tunnelübergangs kann vereinfacht ein Braggspiegel 8 eingesetzt werden, der den entgegengesetzten Leitungstyp des Halbleiterbereichs 7a aufweist. Der Braggspiegel kann also insbesondere n-leitend ausgeführt sein. Entsprechendes gilt für den Halbleiterbereich 6c, der zwischen dem Braggspiegel und dem Tunnelübergang 21 angeordnet sein kann. In einem n-leitenden Braggspiegel 8 ist die Absorption von Strahlung durch freie Ladungsträger gegenüber einem p-leitenden Braggspiegel vorteilhaft verringert, sodass die Konversionseffizienz des Bauelements gegenüber dem in Figur 2 gezeigten vorteilhaft erhöht ist. Der Tunnelübergang 21 ist ebenso wie der Tunnelübergang 5 bevorzugt in einem Intensitätsknoten der Intensitätsverteilung 17 angeordnet.

Der Tunnelübergang 21 gewährleistet eine gute elektrische Anbindung des ersten Kontakts 10 über den Braggspiegel 8 und den Halbleiterbereich 6c, der vorzugsweise den gleichen Leitungstyp wie der Braggspiegel 8 aufweist, an den Halbleiterbereich 7a, der vorzugsweise einen von dem des Halbleiterbereichs 6c und/oder dem des Braggspiegels 8 verschiedenen Leitungstyp aufweist.

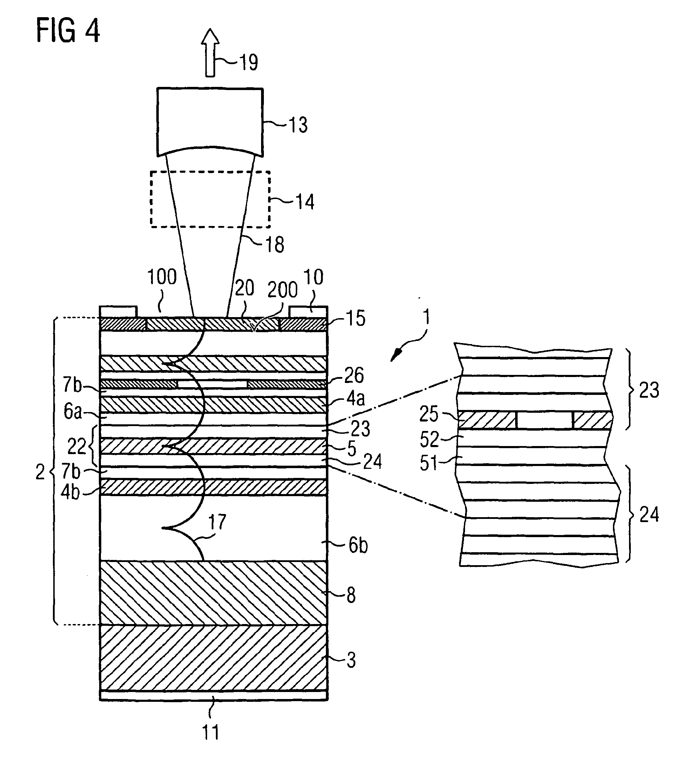

Figur 4 zeigt eine schematische Schnittansicht eines vierten Ausführungsbeispiels eines erfindungsgemäßen strahlungsemittierenden Halbleiterbauelements. Das in Figur 4 gezeigte Ausführungsbeispiel entspricht im Wesentlichen dem in Figur 1 gezeigten. Im Unterschied hierzu ist im Halbleiterkörper 2 ein frequenzselektives Element 22 monolithisch integriert.

Weiterhin ist im Halbleiterkörper, bevorzugt zwischen dem ersten Kontakt 10 und dem diesem nächstliegenden aktiven Bereich 4a, eine Stromblende 26 im Halbleiterkörper ausgebildet. Die Stromblende 26 ist bevorzugt als Oxidblende ausgeführt. Hierzu wird beispielsweise eine (Al)GaAs-Schicht mit hohem Aluminiumgehalt, vorzugsweise 80% oder größer, lateral oxidiert, sodass in einem Zentralbereich ein nichtoxidierter Bereich hoher Leitfähigkeit und im Randbereich des Halbleiterkörpers 2 ein, insbesondere ringartiger, oxidierter Bereich geringer Leitfähigkeit ausgebildet wird. Der Stromfluss im Halbleiterkörper kann so auf den Zentralbereich des Halbleiterkörpers konzentriert werden, wodurch sowohl eine Schwellstromdichte vereinfacht erreicht, als auch die Gefahr nichtstrahlender Rekombination in Randbereichen des Halbleiterkörpers verringert wird.

Anstatt einen Halbleiterbereich für eine Stromblende mittels Oxidation elektrisch zu veröden, kann eine Stromblende auch mittels elektrischer Verödung durch Implantation, z.B. Protonenimplantation, im Halbleiterkörper ausgebildet werden. Um den Stromfluss im Halbleiterkörper lateral zu begrenzen, kann der Halbleiterkörper ferner auch in einem Bereich über Ätzen in eine für die jeweilige Schwellstromdichte geeignete, verringerte laterale Abmessung strukturiert werden (Mesa-Ätzen). Auch über eine derartige Maßnahme kann die laterale Strombegrenzung unterstützt oder erzielt werden.

Das frequenzselektive Element 22 umfasst bevorzugt einen ersten Braggspiegel 23 und einen zweiten Braggspiegel 24. Die beiden Braggspiegel 23 und 24 sind bevorzugt dotiert, wobei der Braggspiegel 23 besonders bevorzugt den gleichen Leitungstyp aufweist wie der Halbleiterbereich 6a, zum Beispiel n-leitend, und der Braggspiegel 24 besonders bevorzugt den gleichen Leitungstyp aufweist wie der Halbleiterbereich 7b, zum Beispiel p-leitend. Der Tunnelübergang 5 ist zwischen den beiden Braggspiegeln des frequenzselektiven Elements angeordnet und grenzt insbesondere an diese an. Mittels der Braggspiegel des frequenzselektiven Elements kann die Intensitätsverteilung im Halbleiterkörper gezielt moduliert werden, sodass die einhüllende Kurve der Intensitätsverteilung des hier lediglich normiert dargestellten Intensitätsverlaufs 17 ein lokales Minimum zwischen den aktiven Bereichen, insbesondere im Bereich des Tunnelübergangs aufweist. Eine Reflektivität der Braggspiegel des frequenzselektiven Elements von 30% oder mehr, bevorzugt von 40% oder mehr, für im Resonator zu verstärkende Strahlung der Wellenlänge λ ist hierfür besonders geeignet.

Auf diese Weise kann die zur Absorption im Tunnelübergang zur Verfügung stehende Strahlungsleistung mit Vorteil verringert werden. Bei der Ausbildung des Halbleiterkörpers ist so die Fertigungstoleranz vorteilhaft erhöht, da auch eine Anordnung des Tunnelübergangs leicht außerhalb eines Intensitätsknotens nicht zu einer maßgeblichen Erhöhung der absorbierten Strahlungsleistung führt.

Um das Ausbilden von separaten, das Erreichen der Lasertätigkeit mittels Verstärkung in einzelnen aktiven Bereichen ermöglichenden Subresonatoren zu verhindern, weisen die Braggspiegel des frequenzselektiven Elements bevorzugt eine Reflektivität von 95% oder weniger, bevorzugt von 90% oder weniger, besonders bevorzugt von 80% oder weniger für im Resonator zu verstärkende Strahlung der Wellenlänge λ auf.

Die Einzelschichten des jeweiligen Braggspiegels des frequenzselektiven Elements können alternativ oder ergänzend auch als λ₁/4-Schichten für Strahlung einer Wellenlänge λ₁ ausgebildet sein, die von der Wellenlänge λ der mittels des Resonators zu verstärkenden Strahlung, für die der Resonator-Braggspiegel 8 zweckmäßigerweise hochreflektiv ausgebildet ist, abweicht. Diese Abweichung kann bis zu 10% betragen.

Weiterhin kann das frequenzselektive Element alternativ oder zusätzlich der longitudinalen Modenselektion dienen. Ein longitudinal monomodiger Betrieb des Halbleiterlaserbauelements kann so unterstützt werden.

Im, insbesondere p-leitenden, Braggspiegel 23 ist ferner bevorzugt eine weitere Stromblende 25, die mit besonderem Vorteil das gleiche Material wie die Stromblende 26 aufweist und/oder an eine Tunnelschicht 52 des Tunnelübergangs 5 angrenzt, integriert. Auch zwischen den aktiven Bereichen kann so der Stromfluss vereinfacht auf den Zentralbereich des Halbleiterkörpers eingeschnürt werden. Eine gleichartige Ausführung der beiden Stromblenden 25 und 26, etwa mittels Halbleiterschichten gleicher Zusammensetzung, erleichtert das Ausbilden von Oxidblenden mit gleich großen, einander vorzugsweise lateral gegenseitig überdeckenden, stromleitenden Aperturen, da gleiche Materialien in der Regel gleiche Oxidationsraten aufweisen.

Ferner kann, anders als dargestellt, ein Intensitätsknoten innerhalb der jeweiligen Stromblende angeordnet sein, da eine Stromblende, insbesondere eine Oxidblende, auch ein maßgebliches Absorptionsvermögen aufweisen kann.

Die Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

Insbesondere ist die Erfindung nicht als auf ein Halbleiterbauelement mit nur zwei aktiven Bereichen beschränkt anzusehen. Vielmehr kann auch eine größere Anzahl von aktiven Bereichen, insbesondere in einem gemeinsamen Resonator, vorgesehen sein. Diese aktiven Bereiche sind vorzugsweise jeweils paarweise durch einen zwischen je zwei aktiven Bereichen angeordneten Tunnelübergang, gegebenenfalls jeweils mit einem den jeweiligen Tunnelübergang umgebenden frequenzselektiven Element, in Serie elektrisch leitend verbunden. Beispielsweise können bis zu zehn aktive Bereiche vorgesehen sein. Auf diese Weise kann die Effizienz des Halbleiterbauelements gegebenenfalls weitergehend erhöht werden.

Ferner kann auch eine ein- oder zweidimensionale, lineare bzw. flächige, vorzugsweise matrixartige, Anordnung von Halbleiterbauelementen als von der Erfindung umfasst angesehen werden. Bevorzugt ist diese Anordnung monolithisch integriert, d.h. mittels epitaktischen Aufwachsens einer Halbleiterschichtenfolge für die Halbleiterkörper der verschiedenen Halbleiterbauelemente und vorzugsweisen Ausbildens der Bauelemente auf einem einzelnen Aufwachssubstrat, ausgeführt. Hierdurch kann eine Vielzahl von Halbleiterbauelementen mit geringem Abstand auf kleinem Raum konzentriert werden. Dies ist für Projektionsanwendungen, bei denen eine geringe Etendue von besonderem Vorteil ist, besonders geeignet.

Weiterhin kann im externen Resonator gegebenenfalls ein Fabry-Perot-Etalon zur longitudinalen Modenselektion vorgesehen sein. Ferner kann der externe Resonator gegebenenfalls auch mittels eines oder einer Mehrzahl von geeigneten reflektiven oder diffraktiven Elementen gefaltet sein. Der Resonator kann so mit einer vorgegebenen Resonatorlänge über Faltung des Resonators vereinfacht mit einem kompakteren Aufbau realisiert sein.

## Patentansprüche

1. Oberflächenemittierendes Halbleiterbauelement (1) mit einer vertikalen Emissionsrichtung, aufweisend:
einen Halbleiterkörper (2) mit einer Mehrzahl von zur Strahlungserzeugung geeigneten, voneinander beabstandet angeordneten aktiven Bereichen (4a, 4b),
wobei
zwischen zwei aktiven Bereichen ein Tunnelübergang (5) monolithisch im Halbleiterkörper integriert ist, und
die beiden aktiven Bereiche mittels des Tunnelübergangs im Betrieb des Halbleiterbauelements elektrisch leitend verbunden sind,
**dadurch gekennzeichnet, dass**
das Halbleiterbauelement zum Betrieb mit einem externen Resonator vorgesehen ist, und
ein frequenzselektives Element (22) im Halbleiterkörper ausgebildet ist, das zwischen zwei aktiven Bereichen (4a, 4b) angeordnet ist, wobei der Tunnelübergang (5) vom frequenzselektiven Element (22) umgeben oder in dieses eingebettet ist.

2. Halbleiterbauelement nach Anspruch 1,
bei dem zwei aktive Bereiche (4a, 4b) als Verstärkungsbereiche zum gemeinsamen Betrieb innerhalb des externen Resonators vorgesehen sind.

3. Halbleiterbauelement nach Anspruch 1 oder 2,
bei dem das Halbleiterbauelement (1) zum Betrieb als elektrisch gepumptes Halbleiterlaserbauelement ausgeführt ist.

4. Halbleiterbauelement nach mindestens einem der vorhergehenden Ansprüche,
das einen internen Spiegel zur Bildung des Resonators aufweist.

5. Halbleiterbauelement nach Anspruch 4,
bei dem ein Pumpstrom durch den internen Spiegel (8) fließt.

6. Halbleiterbauelement nach Anspruch 4 oder 5,
bei dem der interne Spiegel (8) als Braggspiegel ausgeführt ist.

7. Halbleiterbauelement nach Anspruch 6,
bei dem zwischen dem Braggspiegel (8) und dem diesem nächstliegenden aktiven Bereich (4a, 4b) ein weiterer Tunnelübergang (21) angeordnet ist.

8. Halbleiterbauelement nach mindestens einem der vorhergehenden Ansprüche,
bei dem der Halbleiterkörper (2) derart ausgebildet ist, dass ein sich im Betrieb des Halbleiterbauelements (1) innerhalb des Resonators ausbildendes Strahlungsfeld einen Intensitätsknoten innerhalb des Tunnelübergangs aufweist.

9. Halbleiterbauelement nach mindestens einem der vorhergehenden Ansprüche,
bei dem zwei aktive Bereiche (4a, 4b) eine Quantentopfstruktur umfassen.

10. Halbleiterbauelement nach mindestens einem der vorhergehenden Ansprüche,
bei dem der Tunnelübergang (5) zwei Tunnel-Halbleiterschichten verschiedenen Leitungstyps umfasst.

11. Halbleiterbauelement nach mindestens einem der vorhergehenden Ansprüche,
bei dem es vorgesehen ist, im Resonator ein frequenzkonvertierendes Element (14) anzuordnen.

12. Halbleiterbauelement nach mindestens einem der vorhergehenden Ansprüche,
bei dem das frequenzselektive Element (22) monolithisch im Halbleiterkörper integriert ist.

13. Halbleiterbauelement nach mindestens einem der vorhergehenden Ansprüche,
bei dem das frequenzselektive Element (22) derart ausgebildet ist, dass die Intensität innerhalb des frequenzselektiven Elements (22) gemindert ist.

14. Halbleiterbauelement nach mindestens einem der vorhergehenden Ansprüche,
bei dem das frequenzselektive Element (22) einen Braggspiegel (23) umfasst.

15. Halbleiterbauelement nach Anspruch 14, ,
bei dem der Braggspiegel (23) eine Reflektivität von 95% oder weniger, bevorzugt 90% oder weniger, besonders bevorzugt 80% oder weniger, aufweist.

16. Halbleiterbauelement nach Anspruch 14 oder 15,
bei dem das frequenzselektive Element (22) einen weiteren Braggspiegel (24) umfasst.

17. Halbleiterbauelement nach Anspruch 16,
bei dem der weitere Braggspiegel (24) eine Reflektivität von 95% oder weniger, bevorzugt 90% oder weniger, besonders bevorzugt 80% oder weniger, aufweist.

18. Halbleiterbauelement nach Anspruch 16 oder 17,
bei dem der Tunnelübergang (5) zwischen den beiden Braggspiegeln (23, 24) angeordnet ist.

19. Halbleiterbauelement nach mindestens einem der Ansprüche 16 bis 18,
bei dem die beiden Braggspiegel (23, 24) unterschiedliche Leitungstypen aufweisen.

20. Halbleiterbauelement nach mindestens einem der vorhergehenden Ansprüche,
bei dem zwischen zwei aktiven Bereichen (4a, 4b) eine Stromblende (25) im Halbleiterkörper (2) ausgebildet ist.

21. Halbleiterbauelement nach mindestens einem der vorhergehenden Ansprüche, bei dem der Halbleiterkörper ein III-V-Halbleitermaterial, insbesondere ein Material aus den III-V-Halbleitermaterialsystemen Inₓ Ga_{y} Al_{1-x-y} P, Inₓ Ga_{y} Al_{1-x-y} N oder Inₓ Ga_{y} Al_{1-x-y} As, jeweils mit 0≤x≤1, 0≤y≤1 und x+y≤1, enthält.

22. Halbleiterbauelement nach mindestens einem der vorhergehenden Ansprüche, bei dem der Halbleiterkörper ein III-V-Halbleitermaterial, insbesondere ein Material aus den III-V-Halbleitermaterialsystemen InGaAsN, InGaAsSb, InGaAsSbN oder InₓGa₁₋ₓ As_{y}P_{1-y} mit 0≤x≤1 und 0≤y≤1, enthält.

23. Laservorrichtung, die
ein Halbleiterbauelement (1) nach mindestens einem der vorhergehenden Ansprüche umfasst und einen mittels eines dem Halbleiterbauelement zugeordneten externen Spiegels (13) gebildeten externen Resonator aufweist.

## Claims

1. Surface emitting semiconductor component (1) with a vertical emission direction, comprising:
a semiconductor body (2) comprising a plurality of active regions (4a, 4b) which are suitable for the generation of radiation and are spaced apart from one another,
wherein
between two active regions a tunnel junction (5) is monolithically integrated in the semiconductor body, and
the two active regions are electrically conductively connected by means of the tunnel junction during operation of the semiconductor component,
**characterized in that**
the semiconductor component is provided for operation with an external resonator, and a frequency-selective element (22) is formed in the semiconductor body,
which frequency-selective element is arranged between two active regions (4a, 4b), the tunnel junction (5) being surrounded by the frequency-selective element (22) or being embedded therein.

2. Semiconductor component according to Claim 1,
in which two active regions (4a, 4b) are provided as amplifying regions for joint operation within the external resonator.

3. Semiconductor component according to Claim 1 or 2,
in which the semiconductor component (1) is embodied for operation as an electrically pumped semiconductor laser component.

4. Semiconductor component according to at least one of the preceding claims,
which has an internal mirror for forming the resonator.

5. Semiconductor component according to Claim 4,
in which a pump current flows through the internal mirror (8).

6. Semiconductor component according to Claim 4 or 5,
in which the internal mirror (8) is embodied as a Bragg mirror.

7. Semiconductor component according to Claim 6,
in which a further tunnel junction (21) is arranged between the Bragg mirror (8) and the active region (4a, 4b) closest to the latter.

8. Semiconductor component according to at least one of the preceding claims,
in which the semiconductor body (2) is formed in such a way that a radiation field forming within the resonator during operation of the semiconductor component (1) has an intensity node within the tunnel junction.

9. Semiconductor component according to at least one of the preceding claims,
in which two active regions (4a, 4b) comprise a quantum well structure.

10. Semiconductor component according to at least one of the preceding claims,
in which the tunnel junction (5) comprises two tunnel semiconductor layers of different conduction types.

11. Semiconductor component according to at least one of the preceding claims,
in which provision is made for arranging a frequency-converting element (14) in the resonator.

12. Semiconductor component according to at lease one of the preceding claims,
in which the frequency-selective element (22) is monolithically integrated in the semiconductor body.

13. Semiconductor component according to at least one of the preceding claims,
in which the frequency-selective element (22) is formed in such a way that the intensity is reduced within the frequency-selective element (22).

14. Semiconductor component according to at least one of the preceding claims,
in which the frequency-selective element (22) comprises a Bragg mirror (23).

15. Semiconductor component according to Claim 14,
in which the Bragg mirror (23) has a reflectivity of 95% or less, preferably 90% or less, particularly preferably 80% or less.

16. Semiconductor component according to Claim 14 or 15,
in which the frequency-selective element (22) comprises a further Bragg mirror (24).

17. Semiconductor component according to Claim 16,
in which the further Bragg mirror (24) has a reflectivity of 95% or less, preferably 90% or less, particularly preferably 80% or less.

18. Semiconductor component according to Claim 16 or 17,
in which the tunnel junction (5) is arranged between the two Bragg mirrors (23, 24).

19. Semiconductor component according to at least one of Claims 16 to 18,
in which the two Bragg mirrors (23, 24) have different conduction types.

20. Semiconductor component according to at least one of the preceding claims,
in which between two active regions (4a, 4b) a current diaphragm (25) is formed in the semiconductor body (2).

21. Semiconductor component according to at least one of the preceding claims,
in which the semiconductor body contains a III-V semiconductor material, in particular a material from the III-V semiconductor material systems InₓGa_{y}Al_{1-x-y}P, InₓGa_{y}Al_{1-x-y}N or InₓGa_{y}Al_{1-x-y}As, in each case where 0≤x≤1, 0≤y≤1 and x+y≤1.

22. Semiconductor component according to at least one of the preceding claims,
in which the semiconductor body contains a III-V semiconductor material, in particular a material from the III-V semiconductor material systems InGaAsN, InGaAsSb, InGaAsSbN or InₓGa₁₋ₓAs_{y}P₁₋y where 0≤x≤1 and 0≤y≤1.

23. Laser device, which
comprises a semiconductor component (1) according to at least one of the preceding claims and has an external resonator formed by means of an external mirror (13) assigned to the semiconductor component.

## Revendications

1. Composant semi-conducteur à émission de surface (1) avec une direction d'émission verticale, comportant :
un corps semi-conducteur (2) avec des domaines actifs (4a, 4b) aptes à la génération de rayonnement, disposés espacés les uns des autres,
dans lequel
une jonction tunnel (5) est intégrée de manière monolithique dans le corps semi-conducteur entre deux domaines actifs, et les deux domaines actifs sont reliés de manière électriquement conductrice par l'intermédiaire de la jonction tunnel lors du fonctionnement du composant semi-conducteur,
**caractérisé en ce que**
le composant semi-conducteur est pourvu d'un résonateur externe pour le fonctionnement, et
un élément sélecteur de fréquence (22) est formé dans le corps semi-conducteur, disposé entre deux domaines actifs (4a, 4b), la jonction tunnel (5) étant entourée par l'élément sélecteur de fréquence (22) ou étant incluse dans celui-ci.

2. Composant semi-conducteur selon la revendication 1, dans lequel deux domaines actifs (4a, 4b) sont prévus en tant que domaines amplificateurs pour le fonctionnement global à l'intérieur du résonateur externe.

3. Composant semi-conducteur selon la revendication 1 ou 2, dans lequel le composant semi-conducteur (1) est réalisé en tant que composant semi-conducteur pompé électriquement pour le fonctionnement.

4. Composant semi-conducteur selon une au moins des revendications précédentes, comportant un miroir interne pour former le résonateur.

5. Composant semi-conducteur selon la revendication 4, dans lequel un courant de pompage circule à travers le miroir interne (8).

6. Composant semi-conducteur selon la revendication 4 ou 5, dans lequel le miroir interne (8) est réalisé en tant que miroir de Bragg.

7. Composant semi-conducteur selon la revendication 6, dans lequel une autre jonction tunnel (21) est disposée entre le miroir de Bragg (8) et son domaine actif (4a, 4b) le plus proche.

8. Composant semi-conducteur selon une au moins des revendications précédentes, dans lequel le corps semi-conducteur (2) est réalisé de telle sorte qu'un champ de rayonnement se formant à l'intérieur du résonateur lors du fonctionnement du composant semi-conducteur (1), comporte un noeud d'intensité à l'intérieur de la jonction tunnel.

9. Composant semi-conducteur selon une au moins des revendications précédentes, dans lequel deux domaines actifs (4a, 4b) comprenant une structure de puits quantique.

10. Composant semi-conducteur selon une au moins des revendications précédentes, dans lequel la jonction tunnel (5) comprend deux couches tunnel semiconductrices de types de conduction différents.

11. Composant semi-conducteur selon une au moins des revendications précédentes, dans lequel il est prévu de disposer un élément convertisseur de fréquence (14) dans le résonateur.

12. Composant semi-conducteur selon une au moins des revendications précédentes, dans lequel l'élément sélecteur de fréquence (22) est intégré de manière monolithique dans le corps semi-conducteur.

13. Composant semi-conducteur selon une au moins des revendications précédentes, dans lequel l'élément sélecteur de fréquence (22) est réalisé de manière à réduire l'intensité à l'intérieur de l'élément sélecteur de fréquence (22).

14. Composant semi-conducteur selon une au moins des revendications précédentes, dans lequel l'élément sélecteur de fréquence (22) comprend un miroir de Bragg (23).

15. Composant semi-conducteur selon la revendication 14, dans lequel le miroir de Bragg (23) comporte une réflectivité de 95% ou moins, de préférence de 90% ou moins, de manière particulièrement préférée de 80% ou moins.

16. Composant semi-conducteur selon la revendication 14 ou 15, dans lequel l'élément sélecteur de fréquence (22) comporte un miroir de Bragg supplémentaire (24).

17. Composant semi-conducteur selon la revendication 16, dans lequel le miroir de Bragg supplémentaire (24) comporte une réflectivité de 95% ou moins, de préférence de 90% ou moins, de manière particulièrement préférée de 80% ou moins.

18. Composant semi-conducteur selon la revendication 16 ou 17, dans lequel la jonction tunnel (5) est disposée entre les deux miroirs de Bragg (23, 24).

19. Composant semi-conducteur selon une au moins des revendications 16 à 18, dans lequel les deux miroirs de Bragg (23, 24) comportent des types de conduction différents.

20. Composant semi-conducteur selon une au moins des revendications précédentes, dans lequel un diaphragme de courant (25) est formé dans le corps semi-conducteur (2) entre deux domaines actifs (4a, 4b).

21. Composant semi-conducteur selon une au moins des revendications précédentes, dans lequel le corps semi-conducteur contient un matériau semi-conducteur III-V, notamment un matériau des systèmes de matériaux semi-conducteurs III-V Inₓ Ga_{y} Al_{1-x-y} P, Inₓ Ga_{y} Al_{1-x-y} N ou Inₓ Ga_{y} Al_{1-x-y} As, avec respectivement 0≤x≤1, 0≤y≤1 et x+y≤1.

22. Composant semi-conducteur selon une au moins des revendications précédentes, dans lequel le corps semi-conducteur contient un matériau semi-conducteur III-V, notamment un matériau des systèmes de matériaux semi-conducteurs III-V InGaAsN, InGaAsSb, InGaAsSbN ou InₓGa₁₋ₓ As_{y}P_{1-y}, avec 0≤x≤1 et 0≤y≤1.

23. Dispositif laser comportant un composant semi-conducteur (1) selon une au moins des revendications précédentes et un résonateur externe formé au moyen d'un miroir externe (13) associé au composant semi-conducteur.
